# EUROPÄISCHE PATENTANMELDUNG

(11) **EP 0 660 484 A2**
(43) Veröffentlichungstag der Anmeldung: **28.06.1995**
(21) Anmeldenummer: 94118747.8
(22) Anmeldetag: 29.11.1994
(51) Int. Cl.: H02H 9/04, H03K 17/0814

(54) **Elektronische Schützschnellabschaltung**

(30) Priorität: 23.12.1993 DE 4344126
(71) Anmelder: Licentia Patent-Verwaltungs-GmbH, D-60596 Frankfurt (DE)
(72) Erfinder: Meyer, Herbert, Dr., D-24537 Neumünster (DE); Giday, Zoltan, D-24536 Neumünster (DE); Dorn, Willi, D-65520 Bad Camberg (DE)
(74) Vertreter: Vogl, Leo, Dipl.-Ing.

(57) **Zusammenfassung**

Eine elektronische Schützschnellabschaltung mit einem abschaltbaren Freilaufkreis und einer Transient-Spannungsunterdrückungsdiode (7) mit definierter Durchbruchspannung zur Begrenzung der induktiven Spannungsspitzen beim Abschalten des Last- und des Freilaufkreises verhindert das Entstehen von Spannungsspitzen dadurch, daß der Schalttransistor (3) des Freilaufkreises und der Leistungstransistor (5) mit der Schützspule (1) in Reihe und gemeinsam zu der Spannungsunterdrückungsdiode (7) parallel geschaltet und daß die Freilaufdiode (2) in dem Freilaufkreis zwischen den Ausgang des Schalttransistors (3) und dem Eingang der Schützspule (1) angeordnet ist.

## Beschreibung

Die Erfindung betrifft eine elektronische Schützschnellabschaltung gemäß dem Oberbegriff des Anspruchs 1.

Wenn ein Gleichstromschütz mit Freilaufkreis abgeschaltet wird, dann halt es sich für eine Zeit von ca. 70 ms selbst und öffnet erst dann seine Kontakte. Zur Beschleunigung der Abschaltung bzw. des Abbaus der Abschaltspannung sind Freilaufkreise mit Zenerdioden bekanntgeworden, vgl. DE-AS 11 49 810 und DE 36 09 629 A1, wobei im Falle der letztgenannten Schrift die Zenerdiode in den Transistor integriert ist. Diese Lösungen befriedigen jedoch häufig nicht. Um eine Schnellabschaltung zu erlangen, die in einem Bruchteil der vorgenannten Zeitspanne erfolgt, muß der Freilaufstrom unterbunden und dafür gesorgt werden, daß sich die Lastinduktivität entladen kann. Dafür geeignete Schaltungsanordnungen sind z. B. aus der Fachzeitschrift "Elektronik", 23/13.11.87/Seite 143 und 144, bekannt. In diesen Verfahren wird der Freilaufkreis mit einem standardmäßigen Schalttransistor T1 abgeschaltet und die Abschaltenergie der Schützspule entweder über Dioden in die Versorgung zurückgespeist (Bild 5, S. 144) oder über eine Zenerdiode in Wärme umgesetzt (Bild 7, S. 144).

Weiterhin ist durch die DE 39 08 055 C1 eine elektronische Schützschnellabschaltung mit einem abschaltbaren Freilaufkreis und einem Halbleiterbauelement mit definierter Durchbruchspannung zur Begrenzung der induktiven Spannungsspitzen beim Abschalten des Last- und des Freilaufkreises bekannt. Die beim Abschalten der Schützschnellabschaltung entstehenden Spannungsspitzen werden hierbei dadurch abgebaut, daß zur Begrenzung der Spannungsspitzen eine Transient-Spannungsunterdrückungsdiode eingesetzt ist, die parallel zu einem elektronischen Schaltglied geschaltet ist, mit dem der Strom durch die Schützspule zwecks Stromregelung getaktet wird. Weiterhin ist hierbei eine Rückkopplungsdiode in Durchlaßrichtung zwischen dem masseseitigen Anschluß der Spannungsunterdrückungsdiode und dem Eingang der Schützspule geschaltet.

Der Erfindung liegt nun die Aufgabe zugrunde, die elektronische Schützschnellabschaltung gemäß der DE 39 08 055 C1 noch weiter zu vereinfachen und zu verbessern. Diese Aufgabe wird durch die im Patentanspruch 1 gekennzeichneten Merkmale gelöst.

Die Erfindung hat den Vorteil, daß die Ansteuerung des Schalttransistors vereinfacht wird. Der Schalttransistor besteht hierbei aus einem NPN-Transistor, der für hohe Schaltleistungen besser geeignet ist. Hierdurch ist auch eine Umkehrung des Signals nicht erforderlich, was bei Einsatz eines PNP- oder ein N-Kanal Power-MOSFEI-Transistors notwendig gewesen wäre.

Durch die vorteilhafte Ausgestaltung des Erfindungsgegenstandes nach Patentanspruch 2 wird ein noch schnelleres Durchschalten beim Abschalten des Leistungstransistors ermöglicht. Hierdurch wird gewährleistet, daß energiereiche Spannungsspitzen intern abgebaut und nicht ins Netz zurückgedrückt werden.

Weitere vorteilhafte Ausgestaltungen des Erfindungsgegenstandes sind den Unteransprüchen und der folgenden Beschreibung zu entnehmen.

Anhand der Figuren wird die Erfindung näher erläutert. Es zeigen:
- Figur 1: ein Schaltbild für eine elektronische Schützschnellabschaltung und
- Figur 2: ein Schaltbild gemäß Figur 1 mit einer weiteren Verbesserung.

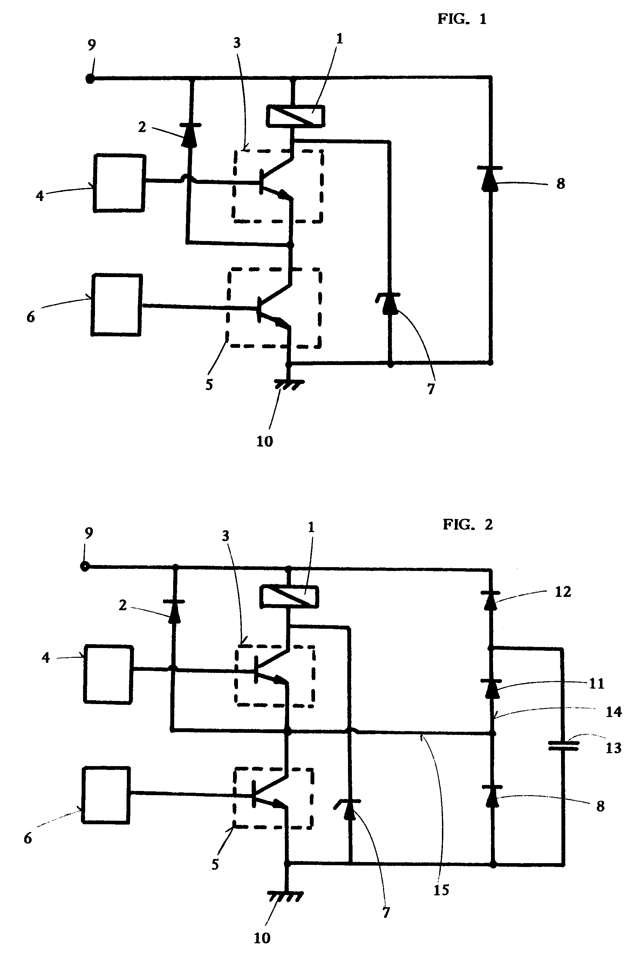

Das in Figur 1 dargestellte Schaltbild zeigt eine elektronische Schützschnellabschaltung mit einem Leistungstransistor 5 der zum Zwecke der Stromregelung den Strom durch die Schützspule 1 taktet, wozu er in einer hier nicht näher erläuterten, Taktregelung 6 eingebunden ist. Damit in den Ausschaltphasen der Stromtaktung das Schütz nicht abfällt, ist die Schützspule 1 in bekannter Weise mit einem Freilaufkreis beschaltet, in dem sich eine Freilaufdiode 2 und ein Schalttransistor 3 befindet, der über eine Steuerung 4 den Freilaufkreis zum Zwecke der Schützschnellabschaltung abschalten kann. Die beim Abschalten des Freilaufkreises entstehende Spannungsspitze wird über eine Transient-Spannungsunterdrückungsdiode 7 begrenzt und die in der Schützspule enthaltene Energie durch den über die Transient-Spannungsunterdrückungsdiode 7 fließenden Strom in Wärme umgewandelt. Der Strom fließt entweder zur Masse 10 oder bei abgeschalteter Masse 10 über eine Rückkopplungsdiode 8 in die Schützspule zurück. Als Transient-Spannungsunterdrückungsdiode 7 kann eine TransZorb-Diode der Firma Semiconductor Industries, Inc., Square D Compony, verwendet werden, die z.B. im "Data-Book 1983" dieser Firma beschrieben ist. Gegenüber herkömmlichen Zenerdioden besitzen diese TransZorb-Dioden den Vorteil einer hohen Stoßstromfestigkeit und extrem schneller Durchschaltzeiten (Pikosekundenbereich).

Die Transient-Spannungsunterdrückungsdiode 7 ist parallel zum Leistungstransistor 5 und zum Schalttransistor 3 geschaltet, um die Transistoren 3 und 5 vor der beim Abschalten entstehenden induzierten Spannung zu schützen. Dabei muß die Diode 7 fast die gesamte Spulenenergie aufnehmen. Mit der Auswahl der Durchbruchspannung der Diode 7 kann die Abschaltzeit des Schützes beeinflußt werden. Mit einer Verkürzung der Abschaltzeit steigt die von der Diode 7 aufzunehmende Leistung bis zu Spitzenleistungen, die, bei Einstellung extrem kurzer Abschaltzeiten, im Kilowattbereicht liegen.

Die in Figur 1 dargestellte Schaltungsanordnung ermöglicht eine vereinfachte Ansteuerung des Schalttransistors 3, wobei der Schalttransistor 3 und der Leistungstransistor 5 mit der Schützspule 1 in Reihe und zu der Spannungsunterdrückungsdiode 7 parallel geschaltet sind. Weiterhin ist die Freilaufdiode 2 des Freilaufkreises zwischen dem Ausgang des Schalttransistors 3 und dem Eingang der Schützspule 1 angeordnet. der Schalttransistor 3 kann hierbei ein PNP-Transistor oder ein N-Kanal Power-MOSFET sein.

Die Entstehung von Spannungsspitzen wird beim Abschalten des Lastkreises mit dem Leistungstransistor 5 dadurch verhindert, daß zwischen dem Ausgang der Rückkopplungsdiode 8 und dem Eingang der Schützspule 1 zwei in Reihe geschaltete Sperrdioden 11, 12 angeordnet sind. Außerdem ist ein Kondensator 13 zu der Rückkopplungsdiode 8 und der ersten in Durchlaßrichtung hinter der Rückkopllungsdiode 8 angeordneten Sperrdiode 11 parallel geschaltet angeordnet. Weiterhin ist die Leitung 14 zwischen der Rückkopplungsdiode 8 und der Sperrdiode 11 über eine Leitung 15 mit dem Ausgang des Schalttransistors 3 elektrisch leitend verbunden. Hierdurch wird ermöglicht, daß beim Abschalten des Leistungstransistors 5 Strom über den Schalttransistor 3 durch die Sperrdiode 11 zu dem Kondensator 13 fließt und dort gespeichert wird. Beim Wiedereinschalten des Leistungstransistors 5 fließt dann neben dem Strom aus dem Netz 9 zusätzlich noch Strom aus dem Kondensator 13. Durch den Kondensator 13 werden energiereiche Spannungsspitzen intern abgebaut und nicht in das Netz zurückgedrückt. Die Sperrdiode 12 verhindert, daß der Kondensator 13 vom Netz 9 geladen wird.

## Patentansprüche

1. Elektronische Schützschnellabschaltung mit einem abschaltbaren Freilaufkreis und einer Transient-Spannungsunterdrückungsdiode mit definierter Durchbruchspannung zur Begrenzung der induktiven Spannungsspitzen beim Abschalten des Last- und des Freilaufkreises, wobei die Spannungsunterdrückungsdiode parallel zu einem elektronischen Schaltglied geschaltet ist, mit dem der Strom durch die Schützspule zwecks Stromregelung getaktet wird, und wobei eine Rückkopplungsdiode in Durchlaßrichtung zwischen dem masseseitigen Anschluß der Spannungsunterdrückungsdiode und dem Eingang der Schützspule geschaltet ist, **dadurch gekennzeichnet**, daß der Schalttransistor (3) und der Leistungstransistor (5) mit der Schützspule (1) in Reihe und gemeinsam zu der Spannungsunterdrückungsdiode (7) parallel geschaltet sind und daß eine Freilaufdiode (2) in dem Freilaufkreis zwischen dem Ausgang des Schalttransistors (3) und dem Eingang der Schützspule (1) angeordnet ist.

2. Schützschnellabschaltung nach Anspruch 1, **dadurch gekennzeichnet**, daß zwischen dem Ausgang der Rückkopplungsdiode (8) und dem Eingang der Schützspule (1) zwei in Reihe geschaltete Sperrdioden (11, 12) angeordnet sind, daß ein Kondensator (13) zu der Rückkopplungsdide (8) und der in Durchlaßrichtung der Rückkopplungsdiode (8) angeordneten ersten Sperrdiode (11) parallel geschaltet ist und daß die Leitung (14) zwischen der Rückkopplungsdiode (8) und der ersten Sperrdiode (11) mit dem Ausgang des Schalttransistors (3) in dem Freilaufkreis elektrisch verbunden ist.
